# EUROPEAN PATENT APPLICATION

(11) **EP 4 835 962 A1**
(43) Date of publication of application: **04.11.2026**
(21) Application number: 24911136.0
(22) Date of filing: 24.12.2024
(51) Int. Cl.: H01L 25/16, H02M 1/00, H02J 7/00, H01L 23/498

(54) **SEMICONDUCTOR MODULE, CHARGER AND ELECTRIC VEHICLE**

(30) Priority: 29.12.2023 CN 202323667131 U
(71) Applicant: BYD Company Limited, Shenzhen, Guangdong 518118 (CN)
(72) Inventor: HU, Rui, Shenzhen, Guangdong 518118 (CN); HE, Xueting, Shenzhen, Guangdong 518118 (CN); YANG, Shengsong, Shenzhen, Guangdong 518118 (CN)
(74) Representative: Mathys & Squire
(86) International application number: PCT/CN2024/141954
(87) International publication number: WO 2025/140211

(57) **Abstract**

The present application discloses a semiconductor module, a charger and an electric vehicle. The semiconductor module includes: a first substrate area, a second substrate area and a third substrate area which extend along the same plane, the second substrate area and the third substrate area being located on the same side of the first substrate area, the first substrate area including a first region and a second region, and the second substrate area including a third region and a fourth region, and the third region being located between the second region and the fourth region; a switching circuit of a power factor correction circuit, which is formed on the first substrate area; a switching circuit of a resonant conversion circuit, including a switching circuit of a resonant conversion primary side circuit formed on the second region and a switching circuit of a resonant conversion secondary side circuit formed on the third region; and a switching circuit of a DC/DC conversion circuit, including a switching circuit of a DC/DC conversion primary side circuit formed on the fourth region and a switching circuit of a DC/DC conversion secondary side circuit formed on the third substrate area.

## Description

This application claims priority to the Chinese patent application filed with the China National Intellectual Property Administration on December 29, 2023, with application number 202323667131.9 and the title "SEMICONDUCTOR MODULE FOR CHARGER, CHARGER AND ELECTRIC VEHICLE", the entire content of which is incorporated herein by reference.

### TECHNICAL FIELD

The present application relates to the field of chargers, and in particular, to a semiconductor module, charger and electric vehicle.

### BACKGROUND ART

Electric vehicles are charged by charging piles, which is consistent with the concept of green environmental protection. Therefore, electric vehicles have been increasingly favored by more and more people in recent years. In the related art, layouts of the charger in electric vehicles require wiring harness management, and the wiring harness management is complicated due to the large number of wiring harnesses.

In addition, the upper-middle-lower layout of each module of existing chargers needs to occupy a large space, which affects the aesthetics of the internal layout of the front cabin to a certain extent. Furthermore, freedom in selecting the installation position of the charger is low.

### SUMMARY OF THE INVENTION

The purpose of the present application is to provide a semiconductor module, charger and electric vehicle. Each circuit module of the semiconductor module is integrated into one module. Compared with the semiconductor module of the charger in the prior art, where each circuit module is arranged in an upper-middle-lower structure and connected by wiring harnesses, the present application not only avoids complex wiring harness connection and complicated wiring harness management, but also occupies a smaller space in the electric vehicle, reserves a larger space for the maintenance of the charger, and provides greater freedom in selecting the installation position of the charger.

A semiconductor module according to an embodiment of the present application includes: a first substrate area, a second substrate area and a third substrate area, wherein the first substrate area, the second substrate area and the third substrate area extend along the same plane, the second substrate area and the third substrate area are located on the same side of the first substrate area, the first substrate area includes a first region and a second region, the second substrate area includes a third region and a fourth region, and the third region is located between the second region and the fourth region; a switching circuit of a power factor correction circuit, wherein the switching circuit of the power factor correction circuit is formed on the first region of the first substrate area; a switching circuit of a resonant conversion circuit, wherein the switching circuit of the resonant conversion circuit includes a switching circuit of a resonant conversion primary side circuit and a switching circuit of a resonant conversion secondary side circuit, the switching circuit of the resonant conversion primary side circuit being formed on the second region, and the switching circuit of the resonant conversion secondary side circuit being formed on the third region; a switching circuit of a DC/DC conversion circuit, wherein the switching circuit of the DC/DC conversion circuit includes a switching circuit of a DC/DC conversion primary side circuit and a switching circuit of a DC/DC conversion secondary side circuit, the switching circuit of the DC/DC conversion primary side circuit being formed on the fourth region, and the switching circuit of the DC/DC conversion secondary side circuit being formed on the third substrate area.

A charger according to an embodiment of the present application includes: the semiconductor module according to the present application; a first capacitor, wherein the first capacitor is part of the power factor correction circuit, and two ends of the first capacitor are connected in parallel with the switching circuit of the resonant conversion primary side circuit; a first transformer, wherein the first transformer is connected between the switching circuit of the resonant conversion primary side circuit and the switching circuit of the resonant conversion secondary side circuit; and a second transformer, wherein the second transformer is connected between the switching circuit of the DC/DC conversion primary side circuit and the switching circuit of the DC/DC conversion secondary side circuit.

An electric vehicle according to an embodiment of the present application includes the charger according to the present application.

Additional aspects and advantages of the present application will be set forth in part in the following description, and in part will become apparent from the following description, or may be understood through practice of the present application.

### BRIEF DESCRIPTION OF THE DRAWINGS

FIG. 1 is a schematic structural diagram of a semiconductor module according to an embodiment of the present application;
FIG. 2 is a top view of the semiconductor module shown in FIG. 1;
FIG. 3 is a top view of the first substrate area of the semiconductor module shown in FIG. 1 and the circuit structure disposed on the first substrate area;
FIG. 4 is a top view of the second substrate area of the semiconductor module shown in FIG. 1 and the circuit structure disposed on the second substrate area;
FIG. 5 is a top view of the third substrate area of the semiconductor module shown in FIG. 1 and the circuit structure disposed on the third substrate area;
FIG. 6 is a schematic structural diagram of the first semiconductor chip and the third semiconductor chip shown in FIG. 1;
FIG. 7 is a schematic structural diagram of the second semiconductor chip serving as an FRD shown in FIG. 1;
FIG. 8 is a schematic structural diagram of the second semiconductor chip serving as an IGBT shown in FIG. 1;
FIG. 9 is a schematic structural diagram of the fourth semiconductor chip and the fifth semiconductor chip shown in FIG. 1;
FIG. 10 is a schematic structural diagram of the sixth semiconductor chip shown in FIG. 1;
FIG. 11 is a schematic structural diagram of the gate resistor shown in FIG. 1;
FIG. 12 is a schematic structural diagram of the thermistor shown in FIG. 1;
FIG. 13 is a schematic diagram of electrical connection wires when the first semiconductor chip or the third semiconductor chip is a SiC MOS chip;
FIG. 14 is a schematic diagram of electrical connection wires when the second semiconductor chip is an IGBT chip;
FIG. 15 is a schematic diagram of electrical connection wires when the fourth semiconductor chip is a Si MOS chip;
FIG. 16 is a schematic diagram of electrical connection wires when the fifth semiconductor chip is a Si MOS chip;
FIG. 17 is a schematic diagram of electrical connection wires when the sixth semiconductor chip is a Si MOS chip;
FIG. 18 is a schematic diagram of electrical connection wires of the thermistor;
FIG. 19 is a schematic diagram of electrical connection wires of the gate resistor;
FIG. 20 is a schematic topological structure diagram of a charger according to an embodiment of the present application;
FIG. 21 is a schematic block diagram of an electric vehicle according to an embodiment of the present application;
FIG. 22 is a schematic diagram of an electric vehicle according to an embodiment of the present application.

### DETAILED DESCRIPTION

The embodiments of the present application are described in detail below, and the embodiments described with reference to the accompanying drawings are exemplary.

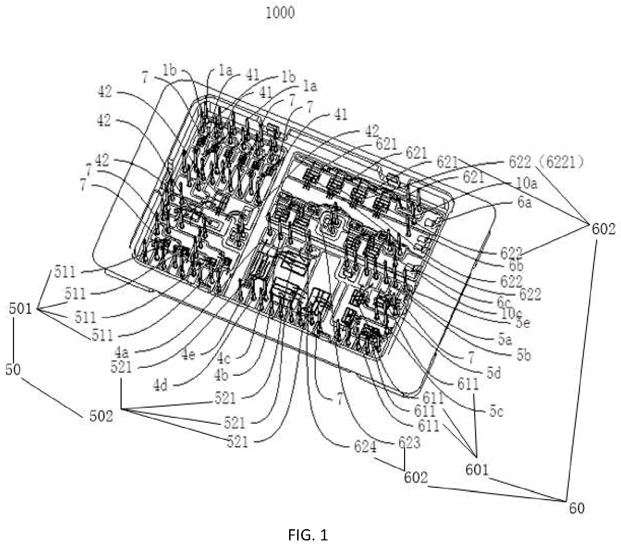

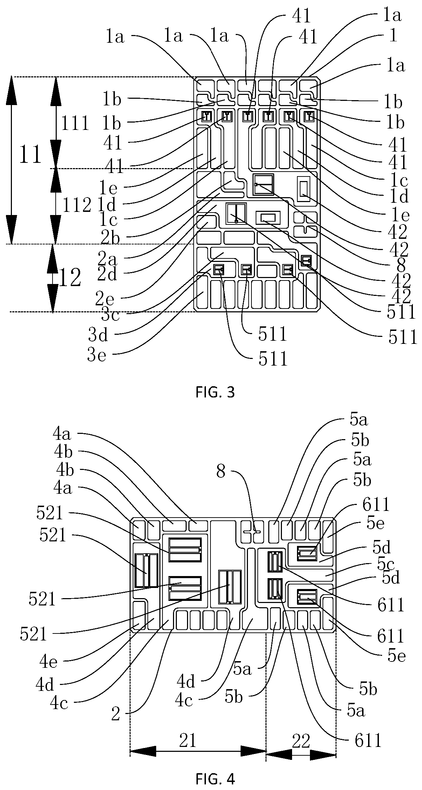

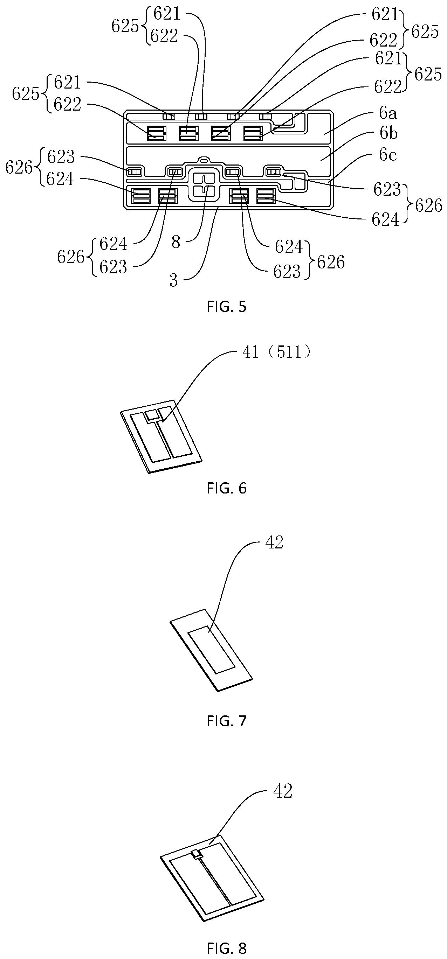

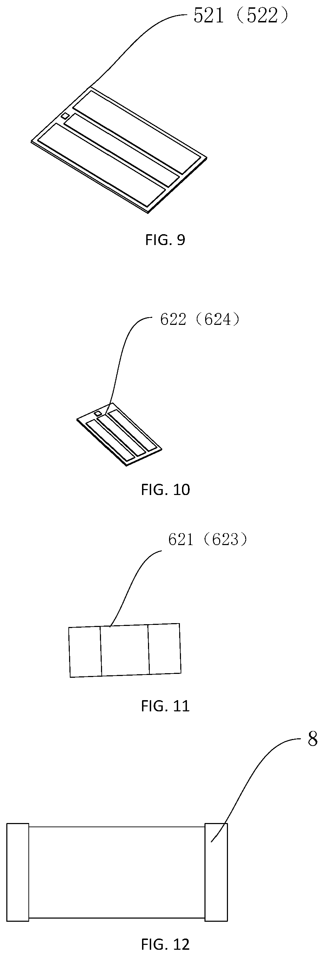

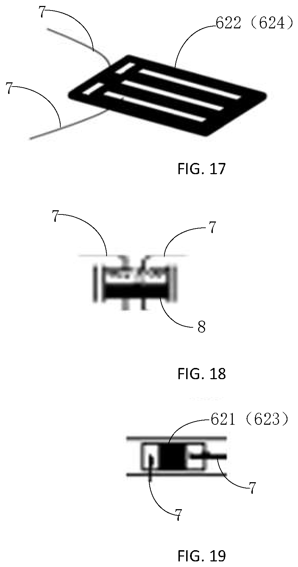

The semiconductor module 1000 according to the embodiment of the present application is described below with reference to FIG. 1 to FIG. 19. The semiconductor module 1000 may be, for example, a semiconductor module of a vehicle-mounted integrated charger. The semiconductor module 1000 can be installed on a charger of an electric vehicle, and connected to a charging pile of the electric vehicle through a charging cable, so as to charge the electric vehicle and provide energy power for the driving of the electric vehicle.

With reference to FIG. 1 to FIG. 5, the semiconductor module 1000 according to the embodiment of the present application includes a first substrate area 1, a second substrate area 2 and a third substrate area 3. The first substrate area 1, the second substrate area 2 and the third substrate area 3 extend along the same plane, in other words, the first substrate area 1, the second substrate area 2 and the third substrate area 3 are located in the same layer. Optionally, the first substrate area 1, the second substrate area 2 and the third substrate area 3 may be different areas of the same substrate; or optionally, the first substrate area 1, the second substrate area 2 and the third substrate area 3 may be located on different substrates. For example, in either of these two optional cases, the substrate may be a ceramic copper-clad substrate, but is not limited thereto.

As shown in FIG. 1 to FIG. 5, the second substrate area 2 and the third substrate area 3 are located on the same side of the first substrate area 1. The first substrate area 1 includes a first region 11 and a second region 12, the second substrate area 2 includes a third region 21 and a fourth region 22, and the third region 21 is located between the second region 12 and the fourth region 22. For example, as shown in FIG. 1, the first substrate area 1 is located on the left side in the semiconductor module 1000, and the second substrate area 2 and the third substrate area 3 are located on the right side in the semiconductor module 1000. The third region 21 is located on the right side of the second region 12, and the fourth region 22 is located on the right side of the third region 21.

As shown in FIG. 1 to FIG. 5, the semiconductor module 1000 further includes a switching circuit 40 of a power factor correction (PFC) circuit, a switching circuit 50 of a resonant conversion circuit (Inductor-Inductor-Capacitor, LLC) and a switching circuit 60 of a DC/DC conversion circuit. Specifically, the switching circuit 40 of the power factor correction circuit is disposed on the first region 11 of the first substrate area 1. The switching circuit 50 of the resonant conversion circuit includes a switching circuit 501 of a resonant conversion primary side circuit and a switching circuit 502 of a resonant conversion secondary side circuit, the switching circuit 501 of the resonant conversion primary side circuit is disposed on the second region 12, and the switching circuit 502 of the resonant conversion secondary side circuit is disposed on the third region 21. The switching circuit 60 of the DC/DC conversion circuit includes a switching circuit 601 of a DC/DC conversion primary side circuit and a switching circuit 602 of a DC/DC conversion secondary side circuit, the switching circuit 601 of the DC/DC conversion primary side circuit is disposed on the fourth region 22, and the switching circuit 602 of the DC/DC conversion secondary side circuit is disposed on the third substrate area 3. It can be seen that the switching circuit 40 of the power factor correction circuit, the switching circuit 50 of the resonant conversion circuit and the switching circuit 60 of the DC/DC conversion circuit are all integrated on the substrate areas located in the same layer. Compared with the related art where each circuit is disposed on different modules, the modules are arranged in an upper-middle-lower order and connected together through wiring harnesses to form a semiconductor module, the layout mode of the semiconductor module 1000 of the present application provides a highly integrated design, can avoid complex wiring harness connection and complex wiring harness management, and can work in a high-power section.

The second substrate area 2 and the third substrate area 3 are jointly located on the same side of the first substrate area 1 in the semiconductor module 1000. The switching circuit 40 of the power factor correction circuit is disposed on the first region 11 of the first substrate area 1, the switching circuit 501 of the resonant conversion primary side circuit of the switching circuit 50 of the resonant conversion circuit is disposed on the second region 12 of the first substrate, the switching circuit 502 of the resonant conversion secondary side circuit of the switching circuit 50 of the resonant conversion circuit is disposed on the third region 21 adjacent to the second region 12, the switching circuit 601 of the DC/DC conversion primary side circuit of the switching circuit 60 of the DC/DC conversion circuit is disposed on the fourth region 22 adjacent to the third region 21, and the switching circuit 602 of the DC/DC conversion secondary side circuit is disposed on the third substrate area 3. The layout of each circuit in these substrate areas realizes the efficient utilization of each area in the first substrate area 1, the second substrate area 2 and the third substrate area 3, and realizes the miniaturization of the semiconductor module 1000, which can reduce the occupied space of the entire semiconductor module 1000 and thus reduce the occupied space of the entire charger. For example, when the semiconductor module 1000 is applied to a charger such as a charger of an electric vehicle, for example, the charger is installed in the front cabin of the electric vehicle, which can provide greater freedom in choosing the specific installation position of the charger including the semiconductor module 1000, and when a certain component in the charger is damaged, more space can be available in the front cabin to facilitate maintenance personnel to maintain the charger.

Therefore, according to the semiconductor module 1000 of the embodiment of the present application, through the above layout of each circuit, complex wiring harness connection and wiring harness management can be avoided, miniaturization of the entire charger can be realized, the occupied space is small, freedom in choosing its installation position is high, and when installed on an electric vehicle for example, a larger maintenance space can be left for maintenance personnel when the charger needs maintenance, which is convenient for the operation of the maintenance personnel.

According to some embodiments of the present application, the first region 11 and the second region 12 are arranged along a first direction, the second region 12, the third region 21 and the fourth region 22 are arranged along a second direction perpendicular to the first direction, and the third substrate area 3 and the second substrate area 2 are arranged along the first direction. Taking FIG. 1 to FIG. 5 as an example, along the first direction AA, in the first substrate area 1, the first region 11 and the second region 12 are arranged in sequence; the third substrate area 3 and the second substrate area 2 are arranged on the right side of the first substrate area 1, and the third substrate area 3 and the second substrate area 2 are arranged in sequence along the first direction AA; the second region 12 of the first substrate area 1, the third region 21 of the second substrate area 2 and the fourth region 22 of the second substrate area 2 are arranged in sequence along the second direction BB perpendicular to the first direction AA. In other words, as shown in FIG. 1, the first region 11 is located above the second region 12, the third substrate area 3 and the second substrate area 2 are located on the right side of the first region 11 and the second region 12, the third substrate area 3 is located above the second substrate area 2, and the third region 21 of the second substrate area 2 is located on the right side of the second region 12 and on the left side of the fourth region 22. With this arrangement, under the condition that the total area of the first substrate area 1, the second substrate area 2 and the third substrate area 3 is the same, the semiconductor module 1000 is prevented from being excessively large in size in any direction, which not only facilitates the layout of each circuit, but also makes it easier to flexibly select the installation positions of the semiconductor module 1000 and the charger including the semiconductor module 1000 in an electric vehicle, such as the front cabin of the electric vehicle.

Optionally, as shown in FIG. 1 to FIG. 5, the first substrate area 1, the second substrate area 2 and the third substrate area 3 all have a substantially rectangular shape.

Optionally, when the first substrate area 1, the second substrate area 2 and the third substrate area 3 are formed on the same substrate, and the substrate also has a substantially rectangular shape.

According to some optional embodiments of the present application, with reference to FIG. 1 to FIG. 5, the first region 11 includes a first sub-region 111 and a second sub-region 112 arranged along the first direction, and the second sub-region 112 is located between the first sub-region 111 and the second region 12. For example, in FIG. 1 to FIG. 3, along the first direction AA, the first sub-region 111, the second sub-region 112 and the second region 12 are arranged in sequence. The switching circuit 40 of the power factor correction circuit includes multiple pairs of first semiconductor chips 41, the multiple pairs of first semiconductor chips 41 are located in the first sub-region 111 and are sequentially arranged along the second direction BB, and two first semiconductor chips 41 in each pair of first semiconductor chips 41 are spaced apart along the second direction BB and are connected in series with each other. With this arrangement, the multiple pairs of first semiconductor chips 41 in the first sub-region 111 realize the PFC fast tube function, and the overall layout of each semiconductor chip of the switching circuit 40 of the power factor correction circuit is regular.

By way of example, as shown in FIG. 1 to FIG. 3, each source of the multiple pairs of first semiconductor chips 41 is electrically connected to each first source signal detection terminal 1a (for example, a detection pin) through an electrical connection wire 7 (for example, a bonding wire), and the first source signal detection terminal 1a is used to detect the signal of the source of the first semiconductor chip 41. In addition, the gates of the multiple pairs of first semiconductor chips 41 are electrically connected to each first gate signal detection terminal 1b in a one-to-one correspondence through the electrical connection wire 7, and the first gate signal detection terminal 1b is used to detect the signal of the gate of the first semiconductor chip 41. Each first source signal detection terminal 1a is spaced apart along the second direction BB on the first sub-region 111, and each first gate signal detection terminal 1b is spaced apart along the second direction BB on the first sub-region 111 and is spaced apart from each first source signal detection terminal 1a in the first direction AA. For example, as shown in FIG. 1 to FIG. 3, each first source signal detection terminal 1a is arranged in a row along the second direction BB, each first gate signal detection terminal 1b is arranged in a row along the second direction BB, and each first source signal detection terminal 1a is arranged on the side of each first gate signal detection terminal 1b away from the second region 12. Thus, the arrangement of the first source signal detection terminal 1a and the first gate signal detection terminal 1b is relatively regular, which facilitates the installation of these detection terminals, and can ensure that the connection between the first source signal detection terminal 1a and the source of the first semiconductor chip 41 and the connection between the first gate signal detection terminal 1b and the gate of the first semiconductor chip 41 are relatively regular. Due to the regular arrangement of the signal detection terminals and the regular connection between the signal detection terminals and the chips, the layout of the internal structure of the semiconductor module 1000 is regular.

According to some embodiments of the present application, as shown in FIG. 1 to FIG. 3, the semiconductor module 1000 further includes a plurality of first power signal positive DC transmission terminals 1c, 1e and a first power signal AC terminal 1d which are located in the first sub-region 111 and used for each pair of first semiconductor chips 41. Especially, in each pair of first semiconductor chips 41, the source of one first semiconductor chip 41 is connected with the drain of the other first semiconductor chip 41 through an electrical connection wire 7, the drain of the one first semiconductor chip 41 is electrically connected with one first power signal positive DC transmission terminal 1c in the plurality of first power signal positive DC transmission terminals, the source of the other first semiconductor chip 41 is electrically connected with the first power signal negative DC transmission terminal 1e in the plurality of first power signal positive DC transmission terminals, and the first power signal AC terminal 1d is connected between the source of the one first semiconductor chip 41 and the drain of the other first semiconductor chip 41. With this arrangement, for each pair of first semiconductor chips 41, an AC signal can be provided to the pair of first semiconductor chips 41 through the first power signal AC terminal 1d, and DC input can be provided to the pair of first semiconductor chips 41 and DC output of the pair of first semiconductor chips 41 can be obtained through the first power signal positive DC transmission terminal 1c and the first power signal negative DC transmission terminal 1e, thereby realizing the circuit function.

According to some embodiments of the present application, with reference to FIG. 1 to FIG. 12, the switching circuit 40 of the power factor correction circuit further includes multiple pairs of second semiconductor chips 42 located in the second sub-region 112, two second semiconductor chips 42 in the same pair of second semiconductor chips 42 are connected in parallel, one of the two second semiconductor chips 42 is an Insulated Gate Bipolar Transistor (IGBT) chip, the other of the two second semiconductor chips 42 is a Fast Recovery Diode (FRD) chip, and different pairs of second semiconductor chips 42 are sequentially connected in series. For example, the drain of the IGBT chip is connected to the anode of the FRD chip, and the source of the IGBT is connected to the cathode of the FRD. With this arrangement, the multiple pairs of second semiconductor chips 42 in the second sub-region 112 realize the PFC slow tube function, and the multiple pairs of second semiconductor chips 42 in the second sub-region 112 realize the PFC slow tube function.

According to some embodiments of the present application, with reference to FIG. 1 to FIG. 3, the source of one second semiconductor chip 42 in each pair of second semiconductor chips 42 is electrically connected to a second source signal detection terminal 2a located in the second sub-region 112 through an electrical connection wire 7, and the gate of one second semiconductor chip 42 in each pair of second semiconductor chips 42 is electrically connected to a second gate signal detection terminal 2b located in the second sub-region 112 through an electrical connection wire 7. Specifically, in the example of FIG. 1, the source of the IGBT chip is connected to a second source signal detection terminal 2a located in the second sub-region 112, and the second source signal detection terminal 2a is used to detect the signal of the source of the IGBT chip, and can also detect the signal of the cathode of the FRD connected in parallel with the IGBT; the gate of the IGBT chip is connected to a second gate signal detection terminal 2b located in the second sub-region 112, and the second gate signal detection terminal 2b is used to detect the signal of the gate of the IGBT chip.

As shown in FIG. 1 to FIG. 3, the semiconductor module 1000 further includes a second power signal AC terminal 2d and a plurality of second power signal negative DC transmission terminals 2c, 2e which are located in the first region 11 and used for the multiple pairs of second semiconductor chips 42. One second power signal positive DC transmission terminal 2c in the plurality of second power signal negative DC transmission terminals in the first region 11 is electrically connected to the drain of the second semiconductor chip 42 in the first pair of second semiconductor chips 42 in the sequentially series-connected multiple pairs of second semiconductor chips 42, one second power signal negative DC transmission terminal 2e in the plurality of second power signal negative DC transmission terminals is electrically connected to the source of the second semiconductor chip 42 in the last pair of second semiconductor chips 42 in the sequentially series-connected multiple pairs of second semiconductor chips 42, and the second power signal AC terminal 2d is connected between two adjacent pairs of second semiconductor chips 42 in the sequentially series-connected multiple pairs of second semiconductor chips 42.

According to some embodiments of the present application, as shown in FIG. 1 to FIG. 12, the first semiconductor chip 41 is a MOS chip, the multiple pairs of first semiconductor chips 41 are three pairs of first semiconductor chips 41, and the multiple pairs of second semiconductor chips 42 are two pairs of second semiconductor chips 42. It will be understood that the number of the multiple pairs of first semiconductor chips 41 is not limited to three pairs, and the number of the multiple pairs of second semiconductor chips 42 is not limited to two pairs. For the sake of brevity, the present application will not give examples one by one.

By way of example, the first semiconductor chip 41 is a SiC MOS chip.

According to some embodiments of the present application, with reference to FIG. 1 to FIG. 4, the switching circuit 501 of the resonant conversion primary side circuit includes multiple pairs of third semiconductor chips 511, and two third semiconductor chips 511 in each pair of third semiconductor chips 511 are connected in series with each other. The switching circuit 502 of the resonant conversion secondary side circuit includes multiple pairs of fourth semiconductor chips 521, and two fourth semiconductor chips 521 in each pair of fourth semiconductor chips 521 are connected in series with each other. The switching circuit 501 of the resonant conversion primary side circuit and the switching circuit 502 of the resonant conversion secondary side circuit together form the switching circuit 50 of the resonant conversion circuit.

According to some embodiments of the present application, with reference to FIG. 1 to FIG. 4, each source of the multiple pairs of third semiconductor chips 511 is electrically connected to a respective third source signal detection terminal 3a located in the second region 12 through an electrical connection wire 7, and the third source signal detection terminal 3a is used to detect the signal of the source of the third semiconductor chip 511. Each gate of the multiple pairs of third semiconductor chips 511 is electrically connected to a respective third gate signal detection terminal 3b located in the second region 12 through an electrical connection wire 7, and the third gate signal detection terminal 3b is used to detect the signal of the gate of the third semiconductor chip 511. Each source of the multiple pairs of fourth semiconductor chips 521 is electrically connected to a respective fourth source signal detection terminal 4a located in the third region 21 through an electrical connection wire 7, and the fourth source signal detection terminal 4a is used to detect the signal of the source of the fourth semiconductor chip 521. Each gate of the multiple pairs of fourth semiconductor chips 521 is electrically connected to a respective fourth gate signal detection terminal 4b located in the third region 21 through an electrical connection wire 7, and the fourth gate signal detection terminal 4b is used to detect the signal of the gate of the fourth semiconductor chip 521.

According to some embodiments of the present application, as shown in FIG. 1 to FIG. 4, the semiconductor module 1000 further includes a third power signal AC terminal 3d and a plurality of third power signal positive DC transmission terminals 3c, 3e which are located in the second region 12 and used for each pair of third semiconductor chips 511. Especially, in each pair of third semiconductor chips 511, the source of one third semiconductor chip 511 is connected with the drain of the other third semiconductor chip 511 through an electrical connection wire 7, the drain of the one third semiconductor chip 511 is electrically connected with one third power signal positive DC transmission terminal 3c in the plurality of third power signal negative DC transmission terminals, the source of the other third semiconductor chip 511 is electrically connected with one third power signal negative DC transmission terminal 3e in the plurality of third power signal negative DC transmission terminals, and the third power signal AC terminal 3d is connected between the source of the one third semiconductor chip 511 and the drain of the other third semiconductor chip 511. With this arrangement, for each pair of third semiconductor chips 511, an AC signal can be provided to the pair of third semiconductor chips 511 through the third power signal AC terminal 3d, and DC input can be provided to the pair of third semiconductor chips 511 and DC output of the pair of third semiconductor chips 511 can be obtained through the third power signal positive DC transmission terminal 3c and the third power signal negative DC transmission terminal 3e.

According to some embodiments of the present application, as shown in FIG. 1 to FIG. 3, the semiconductor module 1000 further includes a fourth power signal AC terminal 4d and a plurality of fourth power signal positive DC transmission terminals 4c, 4e which are located in the third region 21 and used for each pair of fourth semiconductor chips 521. Especially, in each pair of fourth semiconductor chips 521, the source of one fourth semiconductor chip 521 is connected with the drain of the other fourth semiconductor chip 521 through an electrical connection wire 7, the drain of the one fourth semiconductor chip 521 is electrically connected with one fourth power signal positive DC transmission terminal 4c in the plurality of fourth power signal positive DC transmission terminals, the source of the other fourth semiconductor chip 521 is electrically connected with one fourth power signal negative DC transmission terminal 4e in the plurality of fourth power signal positive DC transmission terminals, and the fourth power signal AC terminal 4d is connected between the source of the one fourth semiconductor chip 521 and the drain of the other fourth semiconductor chip 521. With this arrangement, for each pair of fourth semiconductor chips 521, an AC signal can be provided to the pair of fourth semiconductor chips 521 through the fourth power signal AC terminal 4d, and DC input can be provided to the pair of fourth semiconductor chips 521 and DC output of the pair of fourth semiconductor chips 521 can be obtained through the fourth power signal positive DC transmission terminal 4c and the fourth power signal negative DC transmission terminal 4e.

According to some embodiments of the present application, as shown in FIG. 1 to FIG. 12, the multiple pairs of third semiconductor chips 511 are two pairs of third semiconductor chips 511, the multiple pairs of fourth semiconductor chips 521 are two pairs of fourth semiconductor chips 521, and the third semiconductor chip 511 and the fourth semiconductor chip 521 are MOS chips. It will be understood that the number of the multiple pairs of third semiconductor chips 511 is not limited to two pairs, and the number of the multiple pairs of fourth semiconductor chips 521 is not limited to two pairs. For the sake of brevity, the present application will not give examples one by one.

By way of example, the third semiconductor chip 511 is a SiC MOS chip, and the fourth semiconductor chip 521 is a Si MOS chip.

According to some embodiments of the present application, the switching circuit 601 of the DC/DC conversion primary side circuit includes multiple pairs of fifth semiconductor chips 611, and two fifth semiconductor chips 611 in each pair of fifth semiconductor chips 611 are connected in series with each other, wherein the source of one of the two fifth semiconductor chips 611 is connected to the drain of the other fifth semiconductor chip 611.

By way of example, according to some embodiments of the present application, each source of the multiple pairs of fifth semiconductor chips 611 is electrically connected to a fifth source signal detection terminal 5a located in the fourth region 22 through an electrical connection wire 7, and the fifth source signal detection terminal 5a is used to detect the signal of the source of the fifth semiconductor chip 611. Each gate of the multiple pairs of fifth semiconductor chips 611 is electrically connected to a fifth gate signal detection terminal 5b located in the fourth region 22 through an electrical connection wire 7, and the fifth gate signal detection terminal 5b is used to detect the signal of the gate of the fifth semiconductor chip 611.

According to some embodiments of the present application, as shown in FIG. 1 to FIG. 5, the switching circuit 602 of the DC/DC conversion secondary side circuit includes a first group of gate resistors 621, a first group of sixth semiconductor chips 622, a second group of gate resistors 623 and a second group of sixth semiconductor chips 624 arranged along the first direction AA, and the number of sixth semiconductor chips 6221 in each group of sixth semiconductor chips is equal to the number of gate resistors in each group of gate resistors. The sixth semiconductor chips 6221 in the first group of sixth semiconductor chips 622 are spaced apart along the second direction BB, the gate resistors in the first group of gate resistors 621 are spaced apart along the second direction BB, each sixth semiconductor chip 6221 in the first group of sixth semiconductor chips 622 is connected in series with a corresponding one gate resistor in the first group of gate resistors 621 to form a first chip-gate resistor pair 625, and all the first chip-gate resistor pairs 625 are connected in parallel with each other. The sixth semiconductor chips 6221 in the second group of sixth semiconductor chips 624 are spaced apart along the second direction BB, the gate resistors in the second group of gate resistors 623 are spaced apart along the second direction BB, each sixth semiconductor chip 6221 in the second group of sixth semiconductor chips 624 is connected in series with a corresponding one gate resistor in the second group of gate resistors 623 to form a second chip-gate resistor pair 626, and all the second chip-gate resistor pairs 626 are connected in parallel with each other. With this arrangement, the arrangement of each component of the switching circuit of the DC/DC conversion secondary side circuit is relatively regular, which facilitates the wiring of the switching circuit of the DC/DC conversion secondary side circuit, thereby facilitating the manufacture of the semiconductor module 1000 and the entire charger. In addition, the gate resistors can protect the gates of the sixth semiconductor chips 6221 to realize a current sharing function, and can avoid large oscillations of the sixth semiconductor chips 6221 during the turn-on and turn-off processes of the sixth semiconductor chips 6221, thereby ensuring the circuit stability of the charger including the semiconductor module 1000.

For example, in FIG. 1, the first group of gate resistors 621 are arranged in a row along the second direction BB, the first group of sixth semiconductor chips 622 are arranged in a row along the second direction BB, the second group of gate resistors 623 are arranged in a row along the second direction BB, and the second group of sixth semiconductor chips 624 are arranged in a row along the second direction BB. In each first chip-gate resistor pair 625 and each second chip-gate resistor pair 626, one end of the gate resistor is connected to the gate of the sixth semiconductor chip 6221, the other ends of the gate resistors in different first chip-gate resistor pairs 625 are electrically connected to each other through electrical connection wires 7, and the other ends of the gate resistors in different second chip-gate resistor pairs 626 are electrically connected to each other through electrical connection wires 7.

According to some embodiments of the present application, the fifth semiconductor chip 611 is a MOS chip, the sixth semiconductor chip 6221 is a MOS chip, the first group of sixth semiconductor chips 622 and the second group of sixth semiconductor chips 624 each include four sixth semiconductor chips 6221, and the multiple pairs of fifth semiconductor chips 611 are two pairs of fifth semiconductor chips 611. It will be understood that the number and type of the fifth semiconductor chips and the sixth semiconductor chips 6221 are not limited thereto, and for the sake of brevity, the present application will not give examples one by one.

By way of example, the fifth semiconductor chip 611 is a Si MOS chip, and the sixth semiconductor chip 6221 is a Si MOS chip.

According to some embodiments of the present application, with reference to FIG. 1 to FIG. 5, the semiconductor module 1000 includes a fifth power signal AC terminal 5d and a plurality of fifth power signal positive DC transmission terminals 5c, 5e for each pair of fifth semiconductor chips 611. One of the plurality of fifth power signal positive DC transmission terminals 5c is connected to the drain of the one fifth semiconductor chip 611, one of the plurality of fifth power signal negative DC transmission terminals 5e is connected to the source of the other fifth semiconductor chip 611, and the fifth power signal AC terminal 5d is connected between the source of the one fifth semiconductor chip 611 and the drain of the other fifth semiconductor chip 611. With this arrangement, for each pair of fifth semiconductor chips 611, an AC signal can be provided to the pair of fifth semiconductor chips 611 through the first power signal AC terminal 1d, and DC input can be provided to the pair of fifth semiconductor chips 611 and DC output of the pair of fifth semiconductor chips 611 can be obtained through the fifth power signal positive DC transmission terminal 5c and the fifth power signal negative DC transmission terminal 5e.

According to some embodiments of the present application, with reference to FIG. 1 to FIG. 5, the switching circuit 60 of the DC/DC conversion circuit includes a first DC electrode output terminal 6a, a second DC electrode output terminal 6b and a third DC electrode output terminal 6c. The first DC electrode output terminal 6a, the second DC electrode output terminal 6b and the third DC electrode output terminal 6c are located on the third substrate area 3 and spaced apart along the first direction. The first DC electrode output terminal 6a is electrically connected to the drains of the sixth semiconductor chips 6221 in the first group of sixth semiconductor chips 622, the second DC electrode output terminal 6b is electrically connected to the sources of the sixth semiconductor chips 6221 in the first group of sixth semiconductor chips 622 and the second group of sixth semiconductor chips 624, and the third DC electrode output terminal 6c is electrically connected to the drains of the sixth semiconductor chips 6221 in the second group of sixth semiconductor chips 624. The second DC electrode output terminal 6b is configured to be connected to a transformer external to the semiconductor module 1000. After being connected to the transformer, the second DC electrode output terminal 6b outputs its output signal to the power battery.

Further, with reference to FIG. 1 to FIG. 5, a first DC signal detection terminal 10a, a second DC signal detection terminal 10b and a third DC signal detection terminal 10c are arranged in the third substrate area 3. The first DC signal detection terminal 10a, the second DC signal detection terminal 10b and the third DC signal detection terminal 10c are electrically connected to the first DC electrode output terminal 6a, the second DC electrode output terminal 6b and the third DC electrode output terminal 6c respectively, so as to detect the DC signals at these output terminals correspondingly.

According to some embodiments of the present application, with reference to FIG. 1 to FIG. 5, the semiconductor module 1000 further includes thermistors 8 respectively disposed on the first substrate area 1, the second substrate area 2 and the third substrate area 3. At least two thermistor terminals 9 are respectively disposed on the first substrate area 1, the second substrate area 2 and the third substrate area 3, and the two thermistor terminals 9 in the first substrate area 1, the second substrate area 2 and the third substrate area 3 are respectively connected to two ends of the corresponding thermistor 8.

Further, with reference to FIG. 1 to FIG. 5, one thermistor 8 is respectively arranged in the first substrate area 1, the second substrate area 2 and the third substrate area 3, and two ends of each thermistor 8 are respectively connected to the corresponding thermistor terminals 9, so as to detect the temperature conditions of the first substrate area 1, the second substrate area 2 and the third substrate area 3.

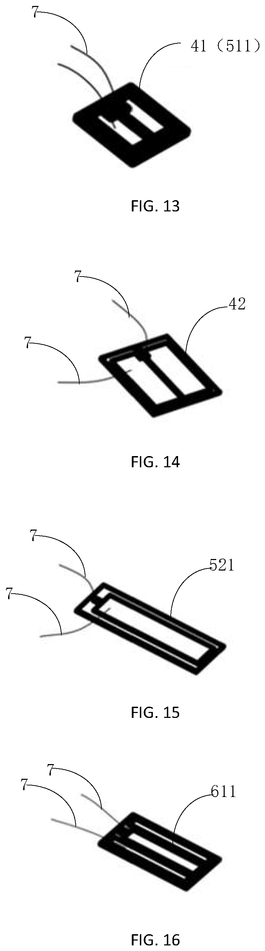

For the electrical connection wire modes of each component in the semiconductor module 1000, reference may be made to FIG. 13 to FIG. 19. Specifically, the source S and gate G of the SiC MOS chip are electrically connected by electrical connection wires, the source S and gate G of the IGBT chip are electrically connected by electrical connection wires, the source S and gate G of the Si MOS chip are electrically connected by electrical connection wires, two ends of the thermistor 8 are electrically connected by electrical connection wires, and two ends of the gate resistor are electrically connected by electrical connection wires.

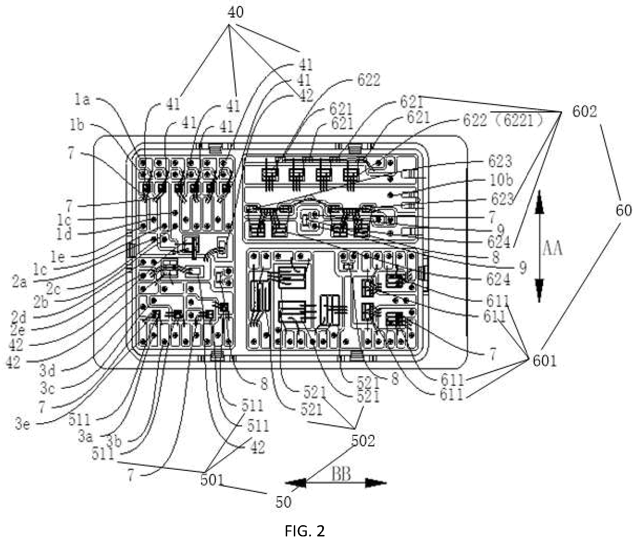

According to some embodiments of the present application, as shown in FIG. 1 and FIG. 2, the thermistor 8 in the first substrate area 1 is disposed on the side of the first region 11 adjacent to the second substrate area 2 and the third substrate area 3, the thermistor 8 in the second substrate area 2 is disposed on the side of the second substrate area 2 adjacent to the third substrate area 3, and the thermistor 8 in the third substrate area 3 is disposed on the side of the third substrate area 3 adjacent to the second substrate area 2. Compared with the prior art where the thermistor is disposed on the housing of the semiconductor module or the housing of the charger, each thermistor 8 of the present application is located on the substrate of the semiconductor, and the measurement result is closer to the junction temperature of the circuit in the semiconductor module, so as to obtain a more accurate measurement result.

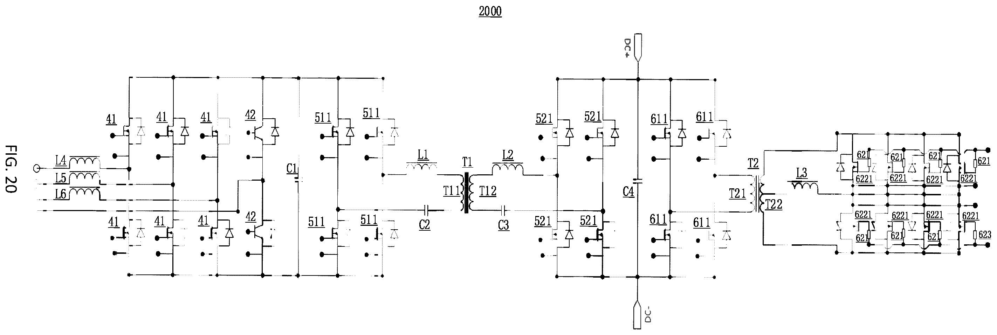

A charger 2000 according to the embodiment of the second aspect of the present application, with reference to FIG. 20 and in combination with FIG. 1 to FIG. 19, includes: the semiconductor module 1000 according to any one of the embodiments of the first aspect of the present application, and a first capacitor C1, wherein the first capacitor C1 is part of the power factor correction circuit, and two ends of the first capacitor C1 are connected in parallel with the switching circuit 501 of the resonant conversion primary side circuit. The charger 2000 further includes a first transformer T1, the first transformer T1 is connected between the switching circuit 501 of the resonant conversion primary side circuit and the switching circuit 502 of the resonant conversion secondary side circuit. The charger 2000 further includes a second transformer T2, the second transformer T2 is connected between the switching circuit 601 of the DC/DC conversion primary side circuit and the switching circuit 602 of the DC/DC conversion secondary side circuit.

Therefore, the charger 2000 according to the embodiment of the present application, by including the above semiconductor module, can avoid complex wiring harness connection and wiring harness management, and can realizeminiaturization of the entire charger 2000 with small, occupied space and high freedom in choosing its installation position. Moreover, when installed on an electric vehicle for example, a larger maintenance space can be reserved for maintenance personnel when the charger 2000 needs maintenance, which facilitates the operation of the maintenance personnel.

According to some embodiments of the present application, with reference to FIG. 20, the multiple pairs of third semiconductor chips 511 are two pairs of third semiconductor chips 511, and the multiple pairs of fourth semiconductor chips 521 are two pairs of fourth semiconductor chips 521. The charger 2000 further includes a first inductor L1, a second capacitor C2, a second inductor L2 and a third capacitor C3. A first end of the first inductor L1 is connected between two third semiconductor chips 511 in one pair of the two pairs of third semiconductor chips 511, and a second end of the first inductor L1 is connected to a first end of the primary winding T11 of the first transformer T1. A first end of the second capacitor C2 is connected between two third semiconductor chips 511 in the other pair of the two pairs of third semiconductor chips 511, and a second end of the second capacitor C2 is connected to a second end of the primary winding T11 of the first transformer T1. A first end of the second inductor L2 is connected between two fourth semiconductor chips 521 in one pair of the two pairs of fourth semiconductor chips 521, and a second end of the second inductor L2 is connected to a first end of the secondary winding T12 of the first transformer T1. A first end of the third capacitor C3 is connected between two fourth semiconductor chips 521 in the other pair of the two pairs of fourth semiconductor chips 521, and a second end of the third capacitor C3 is connected to a second end of the secondary winding T12 of the first transformer T1.

By way of example, with reference to FIG. 20, the charger 2000 further includes a fourth capacitor C4, and the fourth capacitor C4 is connected in parallel with the switching circuit 502 of the resonant conversion secondary side circuit.

According to some embodiments of the present application, with reference to FIG. 20 and in combination with FIG. 1 to FIG. 2, the charger 2000 further includes a third inductor L3, a first end of the third inductor L3 is connected to the secondary winding T22 of the second transformer T2, and a second end of the third inductor L3 is connected between the first group of sixth semiconductor chips 622 and the second group of sixth semiconductor chips 624.

According to some embodiments of the present application, with reference to FIG. 20 and in combination with FIG. 1 to FIG. 2, the multiple pairs of first semiconductor chips 41 include a first pair of first semiconductor chips 41, a second pair of first semiconductor chips 41 and a third pair of first semiconductor chips 41; the charger 2000 further includes a fourth inductor L4, a fifth inductor L5 and a sixth inductor L6. A first end of the fourth inductor L4 is connected to an external power grid, and the other end of the fourth inductor L4 is connected between two first semiconductor chips 41 of the first pair of first semiconductor chips 41; a first end of the fifth inductor L5 is connected to an external power grid, and the other end of the fifth inductor L5 is connected between two first semiconductor chips 41 of the second pair of first semiconductor chips 41; and a first end of the sixth inductor L6 is connected to an external power grid, and the other end of the sixth inductor L6 is connected between two first semiconductor chips 41 of the third pair of first semiconductor chips 41.

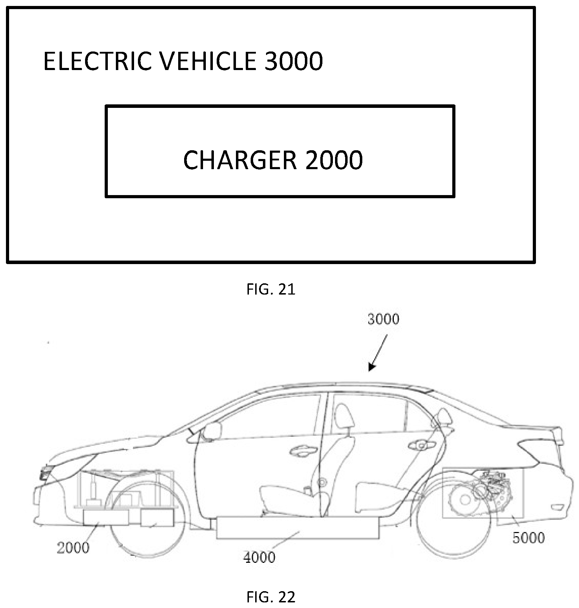

An electric vehicle 3000 according to the embodiment of the third aspect of the present application, as shown in FIG. 21, includes the charger 2000 according to any one of the embodiments of the second aspect of the present application.

Therefore, the electric vehicle 3000 according to the embodiment of the present application, by including the charger 2000 according to the embodiment of the first aspect of the present application, can avoid complex wiring harness connection and wiring harness management, has high freedom in choosing the installation position on the electric vehicle 3000, and can reserve a larger maintenance space for maintenance personnel when the charger 2000 needs maintenance, which facilitates operation of the maintenance personnel.

According to some embodiments of the present application, as shown in FIG. 22, the electric vehicle 3000 further includes an electronic control system 5000 and a battery 4000. The electronic control system 5000 is connected to the charger 2000 and the battery 4000, and the charger 2000 is connected to the battery 4000. The electronic control system 5000 can monitor the state of the battery 4000, and control the charging parameters of the charger 2000 according to the state of the battery 4000, and the charger 2000 charges the battery 4000 according to the charging parameters. Since each circuit module of the semiconductor module in the charger 2000 is integrated into one module, the occupied space of the semiconductor module is effectively reduced, thereby effectively reducing the occupied space of the charger 2000, which can provide more space for the battery 4000 and the electronic control system 5000, further enabling the installation of a battery with a larger capacity to improve the driving range of the electric vehicle 3000, and can provide more space for the electronic components and heat dissipation system of the electronic control system 5000 to improve the performance and reliability of the electronic control system 5000.

By way of example, the electronic control system 5000 may include a Battery Management System (BMS), which is used to monitor the state of the battery 4000, such as voltage, current, temperature, state of charge, etc. The battery management system can also communicate with the charger 2000 to make the charger 2000 adjust the charging parameters.

The electronic control system may also include a Vehicle Control Unit (VCU), which is responsible for the overall management and coordination of the vehicle, including control of the power system, energy management, regenerative braking, thermal management, etc. It may also include a motor controller, which controls the operation of the drive motor, including adjusting the current and voltage to control the speed and torque of the motor.

It will be noted that the above are only preferred embodiments of the present application, and do not limit the present application in any form. Any person skilled in the art, without departing from the scope of the technical solution of the present application, may make any simple modifications, equivalent changes and modifications to the above embodiments based on the technical essence of the present application, which still fall within the scope of the technical solution of the present application.

In the description of the present application, the terms "include", "comprise" or any other variations thereof are intended to cover non-exclusive inclusion, so that a process, method, article or device including a series of elements includes not only those elements, but also other elements not explicitly listed, or elements inherent to such process, method, article or device. Without more restrictions, an element defined by the phrase "including a ..." does not exclude the existence of other identical elements in the process, method, article or device including the element. The term "or" and its variations may mean "and/or". In the embodiments of the present application, the terms "first", "second", etc. are used to distinguish similar objects, and do not necessarily describe a specific order or sequence. In the embodiments of the present application, "multiple" means two or more. "And/or" describes the association relationship of associated objects, indicating that three relationships may exist, for example, A and/or B, may represent: A exists alone, A and B exist at the same time, and B exists alone. The character "/" generally indicates that the associated objects before and after are in an "or" relationship.

It will be understood that the terms "center", "length", "width", "thickness", "upper", "lower", "front", "rear", "left", "right", "transverse", "longitudinal", "top", "bottom", "inner", "outer" and the like indicate the orientation or positional relationship based on the orientation or positional relationship shown in the accompanying drawings, which are only for the convenience of describing the present application and simplifying the description, and do not indicate or imply that the device or element referred to must have a specific orientation, be constructed and operated in a specific orientation, and therefore will not be understood as a limitation of the present application.

In the description of this specification, the description with reference to the terms "one embodiment", "some embodiments", "exemplary embodiments", "example", "specific example", or "some examples" means that the specific features, structures, materials or characteristics described in conjunction with the embodiment or example are included in at least one embodiment or example of the present application. In this specification, the schematic expressions of the above terms do not necessarily refer to the same embodiment or example.

Although the embodiments of the present application have been shown and described, those of ordinary skill in the art will understand that various changes, modifications, substitutions and variations can be made to these embodiments without departing from the principle and purpose of the present application, and the scope of the present application is defined by the claims and their equivalents.

### REFERENCE NUMERALS

semiconductor module 1000; first substrate area 1; second substrate area 2; third substrate area 3;
first semiconductor chip 41; second semiconductor chip 42; third semiconductor chip 511; fourth semiconductor chip 521;
fifth semiconductor chip 611; first group of gate resistors 621; first group of sixth semiconductor chips 622; second group of gate resistors 623; second group of sixth semiconductor chips 624; sixth semiconductor chip 6221; first chip-gate resistor pair 625; second chip-gate resistor pair 626; first direction AA; second direction BB;
electrical connection wire 7; first source signal detection terminal 1a; first gate signal detection terminal 1b; first power signal positive DC transmission terminals 1c, 1e; first power signal AC terminal 1d;
second source signal detection terminal 2a; second gate signal detection terminal 2b; second power signal positive DC transmission terminals 2c, 2e; second power signal AC terminal 2d;
third source signal detection terminal 3a; third gate signal detection terminal 3b; third power signal positive DC transmission terminals 3c, 3e; third power signal AC terminal 3d;
fourth source signal detection terminal 4a; fourth gate signal detection terminal 4b; fourth power signal positive DC transmission terminals 4c, 4e; fourth power signal AC terminal 4d;
fifth source signal detection terminal 5a; fifth gate signal detection terminal 5b; fifth power signal positive DC transmission terminals 5c, 5e; fifth power signal AC terminal 5d;
first DC electrode output terminal 6a; second DC electrode output terminal 6b; third DC electrode output terminal 6c;
thermistor 8; thermistor terminal 9; first DC signal detection terminal 10a; second DC signal detection terminal 10b; third DC signal detection terminal 10c;
first capacitor C1; first transformer T1; primary winding of the first transformer T11; secondary winding of the first transformer T12; second transformer T2; primary winding of the second transformer T21; secondary winding of the second transformer T22; first inductor L1; second capacitor C2; second inductor L2; third capacitor C3; fourth capacitor C4; third inductor L3; fourth inductor L4; fifth inductor L5; sixth inductor L6; charger 2000; electric vehicle 3000.

## Claims

1. A semiconductor module, comprising:
a first substrate area (1), a second substrate area (2) and a third substrate area (3), the first substrate area (1), the second substrate area (2) and the third substrate area (3) extending along the same plane, the second substrate area (2) and the third substrate area (3) being located on the same side of the first substrate area (1), the first substrate area (1) comprising a first region (11) and a second region (12), the second substrate area (2) comprising a third region (21) and a fourth region (22), and the third region (21) being located between the second region (12) and the fourth region (22);
a switching circuit (40) of a power factor correction circuit, the switching circuit (40) of the power factor correction circuit being disposed on the first region (11) of the first substrate area (1);
a switching circuit (50) of a resonant conversion circuit, the switching circuit (50) of the resonant conversion circuit comprising a switching circuit (501) of a resonant conversion primary side circuit and a switching circuit (502) of a resonant conversion secondary side circuit, the switching circuit (501) of the resonant conversion primary side circuit being disposed on the second region (12), and the switching circuit (502) of the resonant conversion secondary side circuit being disposed on the third region (21);
a switching circuit (60) of a DC/DC conversion circuit, the switching circuit (60) of the DC/DC conversion circuit comprising a switching circuit (601) of a DC/DC conversion primary side circuit and a switching circuit (602) of a DC/DC conversion secondary side circuit, the switching circuit (601) of the DC/DC conversion primary side circuit being disposed on the fourth region (22), and the switching circuit (602) of the DC/DC conversion secondary side circuit being disposed on the third substrate area (3).

2. The semiconductor module according to claim 1, wherein the first region (11) and the second region (12) are arranged along a first direction (AA), the second region (12), the third region (21) and the fourth region (22) are arranged along a second direction (BB) perpendicular to the first direction (AA), and the third substrate area (3) and the second substrate area (2) are arranged along the first direction (AA).

3. The semiconductor module according to claim 1 or 2, wherein the first region (11) comprises a first sub-region (111) and a second sub-region (112) arranged along the first direction (AA), the second sub-region (112) is located between the first sub-region (111) and the second region (12), and the switching circuit (40) of the power factor correction circuit comprises multiple pairs of first semiconductor chips (41), the multiple pairs of first semiconductor chips (41) are located in the first sub-region (111) and sequentially arranged along the second direction (BB), and two first semiconductor chips (41) in each pair of first semiconductor chips (41) are spaced apart along the second direction (BB) and connected in series with each other.

4. The semiconductor module according to claim 3, wherein each source of the multiple pairs of first semiconductor chips (41) is electrically connected to a respective first source signal detection terminal (1a) through an electrical connection wire (7), each gate of the multiple pairs of first semiconductor chips (41) is electrically connected to a respective first gate signal detection terminal (1b) through an electrical connection wire, each first source signal detection terminal (1a) is spaced apart along the second direction (BB) on the first sub-region (111), each first gate signal detection terminal (1b) is spaced apart along the second direction (BB) on the first sub-region (111), and is spaced apart from each of the first source signal detection terminals (1a) in the first direction (AA).

5. The semiconductor module according to claim 3 or 4, wherein the semiconductor module further comprises for each pair of first semiconductor chips (41) a first power signal AC terminal (1d) and a plurality of first power signal positive DC transmission terminals (1c, 1e) located in the first sub-region (111), and in each pair of first semiconductor chips (41), a source of one first semiconductor chip (41) is connected to a drain of the other first semiconductor chip (41) through an electrical connection wire (7), a drain of the one first semiconductor chip (41) is electrically connected to one of the plurality of first power signal positive DC transmission terminals (1c, 1e), a source of the other first semiconductor chip (41) is electrically connected to another one of the plurality of first power signal positive DC transmission terminals (1c, 1e), the first power signal AC terminal (1d) is connected between the source of the one first semiconductor chip (41) and the drain of the other first semiconductor chip (41).

6. The semiconductor module according to any one of claims 3 to 5, wherein the switching circuit (40) of the power factor correction circuit further comprises multiple pairs of second semiconductor chips (42) located in the second sub-region (112), two second semiconductor chips (42) in the same pair of second semiconductor chips (42) are connected in parallel, one of the two second semiconductor chips (42) is an Insulated Gate Bipolar Transistor (IGBT) chip, and the other of the two second semiconductor chips (42) is a Fast Recovery Diode (FRD) chip, different pairs of second semiconductor chips (42) are connected in series.

7. The semiconductor module according to claim 6, wherein a source of one second semiconductor chip (42) in each pair of second semiconductor chips (42) is electrically connected to a second source signal detection terminal (2a) located in the second sub-region (112) through an electrical connection wire (7), a gate of one second semiconductor chip (42) in each pair of second semiconductor chips (42) is electrically connected to a second gate signal detection terminal (2b) located in the second sub-region (112) through an electrical connection wire (7).

8. The semiconductor module according to claim 6 or 7, wherein the semiconductor module further comprises for the multiple pairs of second semiconductor chips (42) a second power signal AC terminal (2d) and a plurality of second power signal positive DC transmission terminals (2c, 2e) located in the first region (11), one of the plurality of second power signal positive DC transmission terminals (2c, 2e) in the first region (11) is electrically connected to a drain of a first pair of second semiconductor chips (42) among the sequentially series-connected multiple pairs of second semiconductor chips (42), and the other of the plurality of second power signal positive DC transmission terminals (2c, 2e) is electrically connected to a source of a last pair of second semiconductor chips (42) among the sequentially series-connected multiple pairs of second semiconductor chips (42), the second power signal AC terminal (2d) is connected between two adjacent pairs of the sequentially series-connected multiple pairs of second semiconductor chips (42).

9. The semiconductor module according to any one of claims 6 to 8, wherein the first semiconductor chip (41) is a MOS chip, the multiple pairs of first semiconductor chips (41) are three pairs of first semiconductor chips (41), and the multiple pairs of second semiconductor chips (42) are two pairs of second semiconductor chips (42).

10. The semiconductor module according to any one of claims 6 to 9, wherein the switching circuit (501) of the resonant conversion primary side circuit comprises multiple pairs of third semiconductor chips (511), and two third semiconductor chips (511) in each pair of third semiconductor chips (511) are connected in series with each other;
the switching circuit (502) of the resonant conversion secondary side circuit comprises multiple pairs of fourth semiconductor chips (521), and two fourth semiconductor chips (521) in each pair of fourth semiconductor chips (521) are connected in series with each other.

11. The semiconductor module according to claim 10, wherein each source of the multiple pairs of third semiconductor chips (511) is electrically connected to a respective third source signal detection terminal (3a) located in the second region (12) through an electrical connection wire (7), and each gate of the multiple pairs of third semiconductor chips (511) is electrically connected to a respective third gate signal detection terminal (3b) located in the second region (12) through an electrical connection wire (7); and
each source of the multiple pairs of fourth semiconductor chips (521) is electrically connected to a respective fourth source signal detection terminal (4a) located in the third region (21) through an electrical connection wire (7), and each gate of the multiple pairs of fourth semiconductor chips (521) is electrically connected to a respective fourth gate signal detection terminal (4b) located in the third region (21) through an electrical connection wire (7).

12. The semiconductor module according to claim 10 or 11, wherein the semiconductor module further comprises for each pair of third semiconductor chips (511) a third power signal AC terminal (3d) and a plurality of third power signal positive DC transmission terminals (3c, 3e) located in the second region (12), and for each pair of the third semiconductor chips (511), a source of one third semiconductor chip (511) is connected to a drain of the other third semiconductor chip (511) through an electrical connection wire (7), a drain of the one third semiconductor chip (511) is electrically connected to one of the plurality of third power signal positive DC transmission terminals (3c, 3e), a source of the other third semiconductor chip (511) is electrically connected to another one of the plurality of third power signal positive DC transmission terminals (3c, 3e), and the third power signal AC terminal (3d) is connected between the source of the one third semiconductor chip (511) and the drain of the other third semiconductor chip (511);
the semiconductor module further comprises for each pair of fourth semiconductor chips (521) a fourth power signal AC terminal (4d) and a plurality of fourth power signal positive DC transmission terminals (4c, 4e) located in the third region (21), and for each pair of the fourth semiconductor chips (521), a source of one fourth semiconductor chip (521) is connected to a drain of the other fourth semiconductor chip (521) through an electrical connection wire (7), a drain of the one fourth semiconductor chip (521) is electrically connected to one of the plurality of fourth power signal positive DC transmission terminals (4c, 4e), a source of the other fourth semiconductor chip (521) is electrically connected to another one of the plurality of fourth power signal positive DC transmission terminals (4c, 4e), and the fourth power signal AC terminal (4d) is connected between the source of the one fourth semiconductor chip (521) and the drain of the other fourth semiconductor chip (521).

13. The semiconductor module according to any one of claims 10 to 12, wherein the multiple pairs of third semiconductor chips (511) are two pairs of third semiconductor chips (511), the multiple pairs of fourth semiconductor chips (521) are two pairs of fourth semiconductor chips (521), and the third semiconductor chips (511) and the fourth semiconductor chips (521) are MOS chips.

14. The semiconductor module according to any one of claims 10 to 13, wherein the switching circuit (601) of the DC/DC conversion primary side circuit comprises multiple pairs of fifth semiconductor chips (611), and two fifth semiconductor chips (611) in each pair of fifth semiconductor chips (611) are connected in series with each other, and a source of one of the two fifth semiconductor chips (611) is connected to a drain of the other fifth semiconductor chip (611).

15. The semiconductor module according to claim 14, wherein each source of the multiple pairs of fifth semiconductor chips (611) is electrically connected to a fifth source signal detection terminal (5a) located in the fourth region (22) through an electrical connection wire (7), and each gate of the multiple pairs of fifth semiconductor chips (611) is electrically connected to a fifth gate signal detection terminal (5b) located in the fourth region (22) through an electrical connection wire (7).

16. The semiconductor module according to claim 14 or 15, wherein the switching circuit (602) of the DC/DC conversion secondary side circuit comprises a first group of gate resistors (621), a first group of sixth semiconductor chips (622), a second group of gate resistors (623) and a second group of sixth semiconductor chips (624) arranged along the first direction (AA), and the number of sixth semiconductor chips (6221) in each group of sixth semiconductor chips is equal to the number of gate resistors in each group of gate resistors,
the sixth semiconductor chips (6221) in the first group of sixth semiconductor chips (622) are spaced apart along the second direction (BB), the gate resistors in the first group of gate resistors (621) are spaced apart along the second direction (BB), each sixth semiconductor chip (6221) in the first group of sixth semiconductor chips (622) is connected in series with a corresponding one gate resistor in the first group of gate resistors (621) to form a first chip-gate resistor pair (625), and all the first chip-gate resistor pairs (625) are connected in parallel with each other, and
the sixth semiconductor chips (6221) in the second group of sixth semiconductor chips (624) are spaced apart along the second direction (BB), the gate resistors in the second group of gate resistors (623) are spaced apart along the second direction (BB), each sixth semiconductor chip (6221) in the second group of sixth semiconductor chips (624) is connected in series with a corresponding one gate resistor in the second group of gate resistors (623) to form a second chip-gate resistor pair (626), and all the second chip-gate resistor pairs (626) are connected in parallel with each other.

17. The semiconductor module according to claim 16, wherein the fifth semiconductor chip (611) is a MOS chip, the sixth semiconductor chip (6221) is a MOS chip, each of the first group of sixth semiconductor chips (622) and of the second group of sixth semiconductor chips (624) comprises four sixth semiconductor chips (6221), the multiple pairs of fifth semiconductor chips (611) are two pairs of fifth semiconductor chips (611).

18. The semiconductor module according to any one of claims 14 to 17, wherein the semiconductor module comprises for each pair of fifth semiconductor chips (611) a fifth power signal AC terminal (5d) and a plurality of fifth power signal positive DC transmission terminals (5c, 5e), one of the plurality of fifth power signal positive DC transmission terminals (5c, 5e) is connected to a drain of the one fifth semiconductor chip (611), and the other of the plurality of fifth power signal positive DC transmission terminals (5c, 5e) is connected to a source of the other fifth semiconductor chip (611), the fifth power signal AC terminal (5d) is connected between the source of the one fifth semiconductor chip (611) and the drain of the other fifth semiconductor chip (611).

19. The semiconductor module according to claim 18, wherein the switching circuit (60) of the DC/DC conversion circuit comprises a first DC electrode output terminal (6a), a second DC electrode output terminal (6b) and a third DC electrode output terminal (6c), the first DC electrode output terminal (6a), the second DC electrode output terminal (6b) and the third DC electrode output terminal (6c) are located on the third substrate area (3) and spaced apart along the first direction (AA), the first DC electrode output terminal (6a) is electrically connected to drains of the sixth semiconductor chips (6221) in the first group of sixth semiconductor chips (622), the second DC electrode output terminal (6b) is electrically connected to sources of the sixth semiconductor chips (6221) in the first group of sixth semiconductor chips (622) and the second group of sixth semiconductor chips (624), the third DC electrode output terminal (6c) is electrically connected to drains of the sixth semiconductor chips (6221) in the second group of sixth semiconductor chips (624), the second DC electrode output terminal (6b) is configured to be connected to a transformer external to the semiconductor module.

20. The semiconductor module according to any one of claims 1 to 19, wherein the semiconductor module further comprises thermistors (8) respectively disposed on the first substrate area (1), the second substrate area (2) and the third substrate area (3), at least two thermistor terminals (9) are respectively disposed on the first substrate area (1), the second substrate area (2) and the third substrate area (3), the two thermistor terminals (9) in the first substrate area (1), the second substrate area (2) and the third substrate area (3) are respectively connected to two ends of the corresponding thermistor (8).

21. The semiconductor module according to claim 20, wherein the thermistor (8) in the first substrate area (1) is disposed on a side of the first region (11) adjacent to the second substrate area (2) and the third substrate area (3), the thermistor (8) in the second substrate area (2) is disposed on a side of the second substrate area (2) adjacent to the third substrate area (3), the thermistor (8) in the third substrate area (3) is disposed on a side of the third substrate area (3) adjacent to the second substrate area (2).

22. A charger, comprising:
the semiconductor module (1000) according to any one of claims 1 to 21;
a first capacitor (C1), the first capacitor (C1) being part of the power factor correction circuit, and two ends of the first capacitor (C1) being connected in parallel with the switching circuit (501) of the resonant conversion primary side circuit;
a first transformer (T1), the first transformer (T1) being connected between the switching circuit (501) of the resonant conversion primary side circuit and the switching circuit (502) of the resonant conversion secondary side circuit; and
a second transformer (T2), the second transformer (T2) being connected between the switching circuit (601) of the DC/DC conversion primary side circuit and the switching circuit (602) of the DC/DC conversion secondary side circuit.

23. The charger according to claim 22, wherein the multiple pairs of third semiconductor chips (511) are two pairs of third semiconductor chips (511), and the multiple pairs of fourth semiconductor chips (521) are two pairs of fourth semiconductor chips (521); the charger further comprises:
a first inductor (L1), a first end of the first inductor (L1) is connected between two third semiconductor chips (511) in one pair of the third semiconductor chips (511) among the two pairs of third semiconductor chips (511), and a second end of the first inductor (L1) is connected to a first end of a primary winding (T11) of the first transformer (T1);
a second capacitor (C2), a first end of the second capacitor (C2) is connected between two third semiconductor chips (511) in the other pair of the third semiconductor chips (511) among the two pairs of third semiconductor chips (511), and a second end of the second capacitor (C2) is connected to a second end of the primary winding (T11) of the first transformer (T1);
a second inductor (L2), a first end of the second inductor (L2) is connected between two fourth semiconductor chips (521) in one pair of the fourth semiconductor chips (521) among the two pairs of fourth semiconductor chips (521), and a second end of the second inductor (L2) is connected to a first end of a secondary winding (T12) of the first transformer (T1); and
a third capacitor (C3), a first end of the third capacitor (C3) is connected between two fourth semiconductor chips (521) in the other pair of the fourth semiconductor chips (521) among the two pairs of fourth semiconductor chips (521), and a second end of the third capacitor (C3) is connected to a second end of the secondary winding (T12) of the first transformer (T1).

24. The charger according to claim 23, wherein the charger further comprises a fourth capacitor (C4), the fourth capacitor (C4) is connected in parallel with the switching circuit (502) of the resonant conversion secondary side circuit.

25. The charger according to any one of claims 22 to 24, wherein the charger further comprises a third inductor (L3), a first end of the third inductor (L3) is connected to a secondary winding (T22) of the second transformer (T2), and a second end of the third inductor (L3) is connected between the first group of sixth semiconductor chips (622) and the second group of sixth semiconductor chips (624).

26. The charger according to any one of claims 22 to 24, wherein the multiple pairs of first semiconductor chips (41) comprise a first pair of first semiconductor chips (41), a second pair of first semiconductor chips (41) and a third pair of first semiconductor chips (41); the charger further comprises:
a fourth inductor (L4), a first end of the fourth inductor (L4) is connected to an external power grid, and the other end of the fourth inductor (L4) is connected between two first semiconductor chips (41) of the first pair of first semiconductor chips (41);
a fifth inductor (L5), a first end of the fifth inductor (L5) is connected to an external power grid, and the other end of the fifth inductor (L5) is connected between two first semiconductor chips (41) of the second pair of first semiconductor chips (41); and
a sixth inductor (L6), a first end of the sixth inductor (L6) is connected to an external power grid, and the other end of the sixth inductor (L6) is connected between two first semiconductor chips (41) of the third pair of first semiconductor chips (41).

27. An electric vehicle, comprising the charger (2000) according to any one of claims 22 to 26.

28. The electric vehicle according to claim 27, wherein the electric vehicle further comprises: an electronic control system (5000) and a battery (4000);
the electronic control system (5000) is connected to the charger (2000) and the battery (4000), and the charger (2000) is connected to the battery (4000);
the electronic control system (5000) monitors a state of the battery (4000), and controls charging parameters of the charger (2000) according to the state of the battery (4000);
the charger (2000) charges the battery (4000) according to the charging parameters.
